# EUROPEAN PATENT APPLICATION

(11) **EP 4 471 806 A1**
(43) Date of publication of application: **04.12.2024**
(21) Application number: 23176776.5
(22) Date of filing: 01.06.2023
(51) Int. Cl.: G21K 1/00, G06N 10/40, H01J 49/00

(54) **DEVICE FOR CONTROLLING TRAPPED IONS**

(71) Applicant: Infineon Technologies Austria AG, 9500 Villach (AT)
(72) Inventor: BRANDL, Matthias, 85614 Kirchseeon (DE); COLOMBE, Yves, 9500 Villach (AT); SCHUEPPERT, Klemens Karl Heinrich, 9500 Villach (AT); RÖSSLER, Clemens, 9500 Villach (AT); REPP, Jens, 85570 Markt Schwaben (DE); SCHAECHER, Stephan, 81735 Muenchen (DE)
(74) Representative: Lambsdorff & Lange Patentanwälte Partnerschaft mbB

(57) **Abstract**

A micro-fabricated device (1300) for controlling trapped ions (180) includes a first substrate (120) having a main surface. A structured first metal layer (130) is disposed over the main surface of the first substrate, the structured first metal layer comprising a plurality of electrodes configured to trap an ion at a position space above the first substrate. The micro-fabricated device further includes a first optical layer disposed beneath or over the position, the first optical layer comprising a first laser light path (1350) extending in a direction substantially parallel to the main surface of the first substrate. The first optical layer comprises one or more light processing elements (1370) for manipulating laser light (140) on the first laser light path.

## Description

### Technical Field

This disclosure relates generally to the field of ion traps, and in particular to ion traps for quantum computing or atomic clocks and methods of manufacturing such devices.

### Background

Trapped ions are a promising candidate for use as qubits (quantum bits) in quantum computers since they can be trapped with long lifetimes in a scalable array by virtue of electromagnetic fields. Presently, the most advanced ion traps can control about 50 qubits individually and can maintain up to 16 qubits in a fully entangled state. Future quantum computers may need to increase the number of fully controllable qubits to more than 50 to outperform classical supercomputers.

Typically, laser light is used for trapped ion quantum computing. In addition, different laser light, each having specific properties such as frequency (or spectrum of frequencies), intensity, polarization and/or phase may be needed. These specific properties of the laser light may depend on the type of operation that is to be performed with the laser light with respect to the trapped ions, e.g. cooling, gate operations and so on.

For example, cooling may need to be carried out at many places in an ion trap device, such as a quantum computer. A micro-fabricated ion trap device may need to have a large number of places where ions can be cooled. Cooling may require up to three or even more laser beams with specific frequencies, intensities and polarizations.

As cooling, processing and detection may be performed in a large number of different positions in an ion trap, there is a need for a large number of different laser beams in an ion trap. Therefore, the optical system of the ion trap may need to be scaled with the ion trap which may be challenging when fabricating such ion traps.

In addition, the laser beams should reach the ions while avoiding hitting the surfaces of the ion trap. With the scaling of the ion trap to a higher number of ions and laser beams, this specification is also increasingly difficult to meet.

Another problem that may be present as the ion trap device is scaled to larger number of ions and laser beams are the increase in crosstalk and stray light.

### Summary

According to an aspect of the disclosure, a micro-fabricated device for controlling trapped ions includes a first substrate having a main surface. A structured first metal layer is disposed over the main surface of the first substrate, the structured first metal layer comprising a plurality of electrodes configured to trap an ion at a position above the first substrate. The micro-fabricated device further includes a first optical layer disposed beneath or over the position, the first optical layer comprising a first laser light path extending in a direction substantially parallel to the main surface of the first substrate, wherein the first optical layer comprises one or more light processing elements for manipulating laser light on the first laser light path.

### Brief description of the drawings

The elements of the drawings are not necessarily to scale relative to each other. Like reference numerals designate corresponding similar parts. The features of the various illustrated embodiments can be combined unless they exclude each other and/or can be selectively omitted if not described to be necessarily required. Embodiments are depicted in the drawings and are exemplarily detailed in the description which follows.
Figure 1 is a schematic cross-sectional partial view of an exemplary micro-fabricated device for controlling trapped ions having, e.g., a flat mirror for redirecting laser light from a direction perpendicular to a direction parallel to the ion trap surface.
Figure 2 is a schematic cross-sectional partial view of an exemplary micro-fabricated device for controlling trapped ions having, e.g., a concave mirror for redirecting laser light.
Figure 3 is a schematic cross-sectional partial view of an exemplary micro-fabricated device for controlling trapped ions having optical access from the top and an optical waveguide for coupling the laser light into the device.
Figure 4 is a schematic cross-sectional partial view of an exemplary micro-fabricated device for controlling trapped ions having optical access from the bottom and a waveguide for redirecting laser light towards the ions. The light is focused onto the ions with a (micro) lens.
Figure 5 is a schematic cross-sectional partial view of an exemplary micro-fabricated device for controlling trapped ions having optical access from the bottom and a waveguide for redirecting laser light. The light is focused onto the ions with a diffractive (micro) lens.
Figure 6 is a schematic cross-sectional partial view of an exemplary micro-fabricated device for controlling trapped ions having an optical exit at the bottom and an optical waveguide for coupling-in the laser light to the device. The light is reflected of a planar mirror and focused with a (micro) lens.
Figure 7 is a schematic cross-sectional partial view of an exemplary micro-fabricated device for controlling trapped ions having an optical exit at the bottom and an optical waveguide for coupling-in the laser light to the device. A curved mirror reflects and focuses the light on the ion position.
Figure 8 is a schematic cross-sectional partial view of an exemplary micro-fabricated device for controlling trapped ions having an optical element for redirecting laser light out of the device.
Figure 9 is a schematic cross-sectional partial view of the exemplary micro-fabricated device of Figure 8 with a light absorber for absorbing the laser light redirected out of the device.
Figure 10 is a schematic cross-sectional partial view of the exemplary micro-fabricated device of Figure 9 with the mirror replaced by a light absorber attached to the first substrate.
Figures 11A-11C are schematic cross-sectional partial views of examples of 3D micro-fabricated devices for controlling trapped ions.
Figure 12 is a schematic cross-sectional partial view of an exemplary micro-fabricated 3D device for controlling trapped ions having an optical element for redirecting laser light out of the device.
Figures 13A-13E are schematic cross-sectional partial views of examples of 2D and 3D micro-fabricated devices for controlling trapped ions having an optical layer configured as a laser light manipulation layer and/or a laser light redistribution layer.
Figures 14A-14B are schematic cross-sectional partial views of examples of 3D micro-fabricated devices for controlling trapped ions comprising an optical waveguide connector or a substrate that accomodates an optical focussing element.
Figures 15A-15F are schematic cross-sectional partial views of examples of 2D and 3D micro-fabricated devices for controlling trapped ions having an output port for passing detection light from an ion trapped in an ion trap.
Figure 16 is a schematic cross-sectional conceptual view of a layer stack implementation of micro-fabricated devices for controlling trapped ions, the layer stack including a 2D trap layer, an electrical layer, and optical layers.
Figure 17 is a schematic cross-sectional conceptual view of a layer stack implementation of micro-fabricated devices for controlling trapped ions, the layer stack including optical layers, a 3D trap layer, and an electrical layer.
Figure 18 illustrates a schematic cross-sectional view and a schematic top view of an exemplary first structured metal layer of an ion trap of a micro-fabricated device for controlling a trapped ion.
Figure 19 illustrates the top view of Figure 18 with two laser light beams directed to a light interaction region.
Figure 20 illustrates the top view of Figure 18 with two laser light beams directed to the light interaction region.
Figure 21 illustrates a schematic top view of a repeating pattern of the exemplary first structured metal layer of Figure 18 and two light interaction regions as shown in Figure 20.
Figure 22A is a schematic illustration of a beam splitter.
Figure 22B illustrates an exemplary waveguide beam splitter.
Figure 23A is a schematic illustration of an electro-optical modulator for phase modulation.
Figure 23B is a schematic illustration of an electro-optical modulator for amplitude modulation and/or polarization modulation.
Figure 23C illustrates an exemplary electro-optical modulator.

### Detailed description

The words "over" or "on" or "beneath" with regard to a part, element or material layer formed or located or disposed or arranged or placed "over" or "on" or "beneath" a surface may be used herein to mean that the part, element or material layer be located (e.g. placed, formed, arranged, disposed, placed, etc.) "directly on" or "directly under", e.g. in direct contact with, the implied surface. The word "over" or "on" or "beneath" used with regard to a part, element or material layer formed or located or disposed or arranged or placed "over" or "on" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

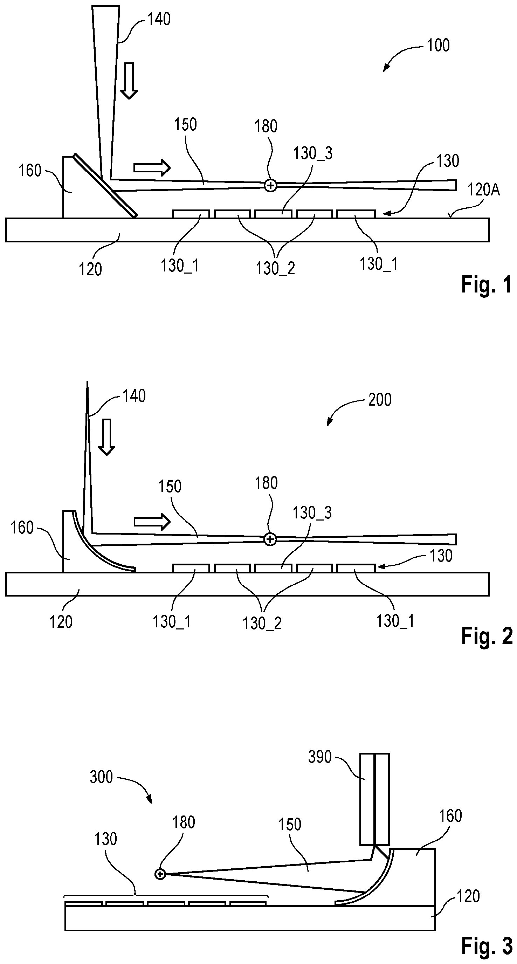

Referring to Figure 1, a micro-fabricated device 100 (such as a micro-fabricated ion trap) for controlling trapped ions includes a first substrate 120. The first substrate 120 has an upper main surface 120A. A structured first metal layer 130 is disposed over the main surface 120A. The structured first metal layer 130 may include electrodes 130_1, 130_2, 130_3 configured to trap one or more ions 180 at a position above the first substrate 120.

The first substrate 120 (and also the second substrate 1120 discussed further below) may, e.g., be a bulk single material substrate or a processed substrate including a base substrate and one or a plurality of layers (dielectric layers, metal layers) disposed over the base substrate. For example, the micro-fabricated device 100 for controlling trapped ions may be implemented with multiple metal layers rather than only the first metal layer 130 (i.e. the electrode layer) illustrated in Figure 1. For example, the substrate 120 may include a routing metal layer (not shown) and an insulating layer (not shown) covering the routing metal layer, wherein the routing metal layer and the first metal layer 130 forming the electrodes of the micro-fabricated device 100 (ion trap) are electrically interconnected by vias running through the insulating layer. In this and other cases, the first surface 120A of the first substrate 120 may, e.g., be formed by the upper surface of the insulating layer (not shown). Such insulating layer may, e.g., be of an inorganic dielectric material, e.g. silicon oxide and/or silicon nitride.

A variety of different layouts of the electrodes 130_1, 130_2, 130_3 is possible. For example, the electrodes 130_1, 130_2, 130_3 may be shaped as stripes. In the example of Figure 1, the electrodes 130_1 may be ground electrodes or a plurality of DC electrodes, the electrodes 130_2 may be RF electrodes and the central electrode 130_3 may be one or a plurality of ground or DC electrodes.

For example, the ion trap may be a linear ion trap. Typically, linear ion traps use RF trapping in two dimensions and static electric-field trapping (i.e. DC trapping) in the third dimension.

In addition, the micro-fabricated device 100 includes a first optical element 160 which is fixedly attached to the first substrate 120. The first optical element 160 receives input laser light 140 from a direction perpendicular or inclined to the main surface 120A of the first substrate 120. The first optical element 160 redirects the input laser light 140 in a direction substantially parallel to the main surface 120A of the first substrate 120 towards the position of the trapped ion 120. The redirected laser light is denoted by reference sign 150.

As apparent from Figure 1 and the following examples, the micro-fabricated device 100 uses the third direction perpendicular or inclined to the substrate 120 as a part of the laser light delivery path, before the input laser light 140 is redirected into a plane which is substantially parallel to the main surface 120A of the substrate 120. The available space above (or, as will be shown in the following examples, beneath) the first substrate 120 scales quadratically with the lateral size of the micro-fabricated device 100. As such, according to the present disclosure, this space (above or below the substrate) may be used for preparing a plurality of laser beams (such as the input laser light 140) with one or more specific properties (such as polarization, intensity, spectrum of frequencies). The prepared laser beams (such as the input laser light 140) can then be provided 140 to the ions 180 from a direction perpendicular or inclined to the main surface 120A of the first substrate 120 to the ions 180 in the micro-fabricated device by redirecting the laser beams (such as the input laser light 140) in a direction substantially parallel to the main surface 120A via the first optical element 160. That way, scaling the micro-fabricated device 100 to larger numbers of ions (and larger numbers of laser beams) may be facilitated by means of redirection of laser light.

In Figure 1 and in the following Figures only one ion trapping position of the micro-fabricated device 100 for controlling trapped ions is depicted. For example, cooling and recooling may need to be performed at many positions. For a (scaled) micro-fabricated device 100, a position in the trap, where ions can be cooled, may be needed every N segment of the structured first metal layer 130. In examples, N could be as low as 10 or 100. This means that a micro-fabricated device 100 with e.g., thousands of segments may require hundreds of positions to cool ions. Cooling might require up to 3 (or even more) laser beams (such as incoming laser light 140) with specific properties (such as frequency, intensity and/or polarization). It can be seen from the above that the number of laser beams to be directed into the micro-fabricated device 100 (and that may optionally be directed out of the micro-fabricated device after the laser beam interacted with the ion) may be high.

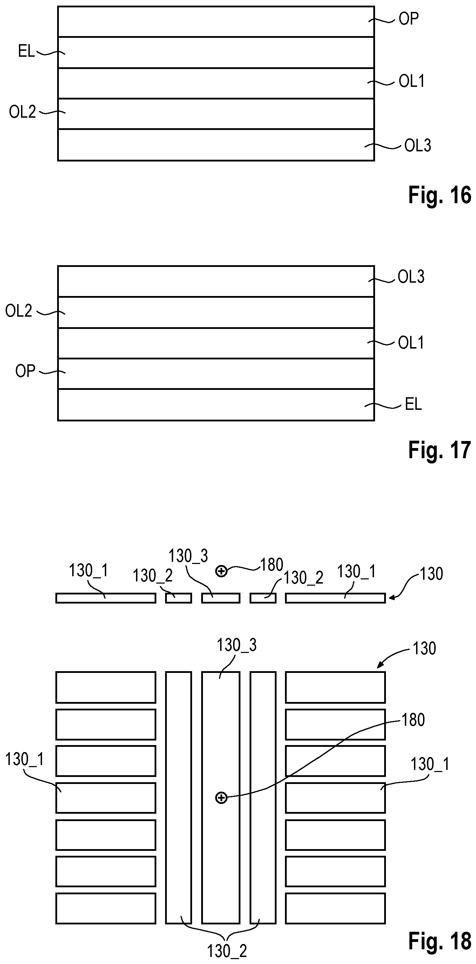

Figure 18 illustrates a schematic cross-sectional view and a schematic top view of an exemplary first structured metal layer 130 of a micro-fabricated device 100 for controlling a trapped ion 180. The upper cross-sectional view may correspond to the exemplary first structured metal layer 130 of Figure 1. The lower top view representation illustrates the stripe-shape design of ground electrode 130_3 and RF-electrodes 130_2 and two arrays of DC electrodes 130_1 arranged at both sides of the electrode layout. The DC electrodes of the arrays of DC electrodes may be connected to different DC voltages to control the position of the ion 180 along the direction of the stripe-shaped ground electrode 130_3.

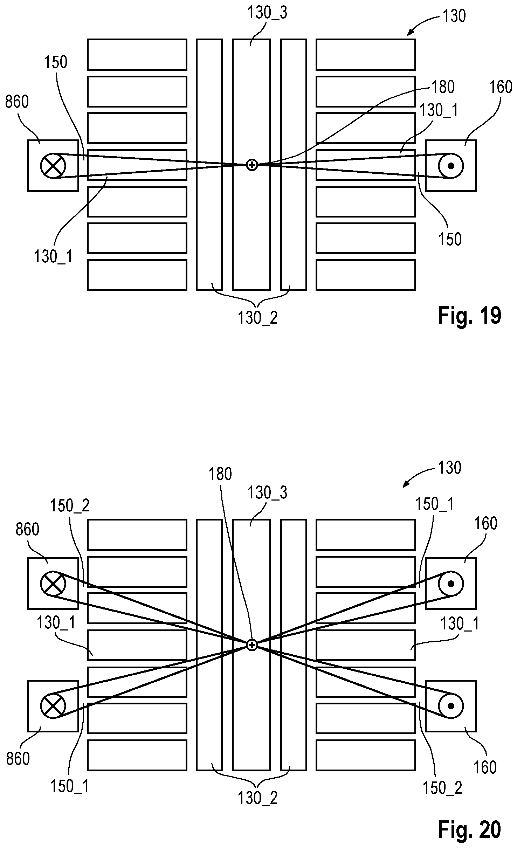

Figure 19 illustrates a beam of input laser light 150 (such as the input laser light 140) directed to a light interaction position via the first optical element 160 from a top view. The first optical element 160 may receive the input laser light from a direction perpendicular or inclined to the main surface of the first substrate, and redirect the input laser light in a direction substantially parallel to the main surface of the first substrate towards the ion position above the first substrate. The electrodes of the structured first metal layer 130 may be operated such that the beam of the input laser light 150 may interact with an ion 180 that is trapped at the light interaction position. Optionally, the input laser light 150 may be redirected by a second optical element 860 away from a direction substantially parallel to the main surface 120A.

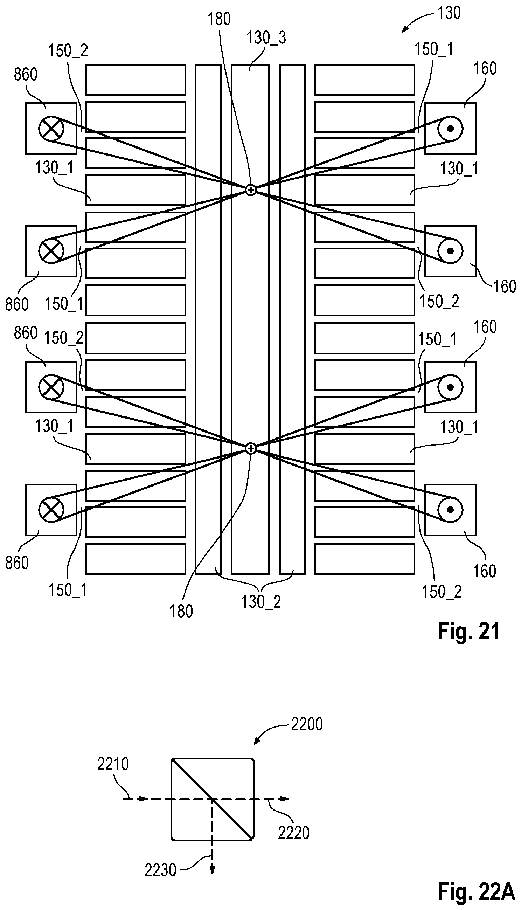

Figure 20 illustrates two beams of laser light 150_1, 150 2 directed to a light interaction position. The laser lights 150_1 and 150_2 may have different properties (such as different frequency and/or intensity and/or polarization). In this example, both beams of laser light 150_1, 150_2 are redirected and/or focused onto a single position (which may correspond to the position of a trapped ion 180). Again, the laser lights 150_1 and 150_2 may optionally be redirected by second optical elements 860 away from a direction substantially parallel to the main surface 120A. Figure 21 illustrates a repeating pattern of the exemplary first structured metal layer 130 of Figures 18 and 19. In this example, two light interaction positions are shown. For example, every 8 or 10 segments of DC electrodes 130_1 the light interaction region may repeat. Of course, different arrangements are also contemplated, such as more than two laser lights being redirected and focussed on a single ion position and/or repeating the segments more often (such as every 5 segments) or less often (such as every 15, 20, 30, 40, or more segments), for example.

For example, an ion trapping position (or light interaction position as displayed Figures 18 to 21) may be located in a loading zone, a storage zone or a processing zone of ion(s) 180 in a trapped ion device. In a loading zone the ions 180 are typically ionized and cooled by employing laser cooling. Typically, ions 180 are generated by thermal- or laser-based evaporation of bulk material to generate neutral atoms. Laser-based ionization of the neutral atoms allows for trapping by an electromagnetic or electric field. The ion(s) 180 may be cooled by employing laser cooling and stored in a loading zone or a storage zone for later use. Typically, the evaporation and the ionization may require relatively high energy laser light.

Trapped and cooled ions 180 may then be transferred from a loading zone or storage zone to a processing zone. In the processing zone, quantum operations between trapped ions 180 may be carried out. Further, if the ions 180 are trapped as qubits, the qubit state may optionally be read out. Typically, a processing zone requires the access of laser light for laser-based state preparation of trapped ions 180 and laser light for reading out the qubit states. As discussed above, at each of these zones one or more laser lights with specific properties may be needed to perform these tasks.

For example, the first optical element 160 may be a mirror. In Figure 1 the first optical element 160, is shown as a flat mirror. The input laser light 140 may, e.g., be a converging laser beam 140, which can be focused by a flat mirror onto the ion 180.

Referring to the micro-fabricated device 200 of Figure 2, the first optical element 160 may be implemented by a concave mirror. In this case, the input laser light 140 may be shaped as a collimated or divergent beam which is focused by the concave mirror onto the ion(s) 180.

In both examples of Figure 1 and 2, the optical element 160 may include a metallic mirror surface as a reflective coating of the optical element 160. The metallic mirror surface may, e.g., be electrically contacted to an electrode (e.g. ground electrode 130_1) to suppress stray charges. The optical element 160 having a metallic mirror surface can be positioned further away from the ion 180 than in diffractive mirror approaches. This may minimize the amplitude of stray fields seen by the ion 180 due to the laser beam reflection on the mirror.

In Figures 1 and 2, the beam of input laser light 140 may be provided by free-space beam delivery, i.e. by free-space optics (not shown). In other examples the input laser light 140 may be delivered by an optical waveguide, e.g. an optical fiber. Figures 3 to 7 (as well as other Figures further below) illustrate micro-fabricated devices 300, 400, 500, 600, 700, 1100, 1200, 1300, 1400, 1500 provided partly with one or more optical waveguides 390 for providing the input laser light 140 to the first optical element 160. An optical waveguide 390 may include at least one of an optical fiber, a written waveguide or a structured waveguide.

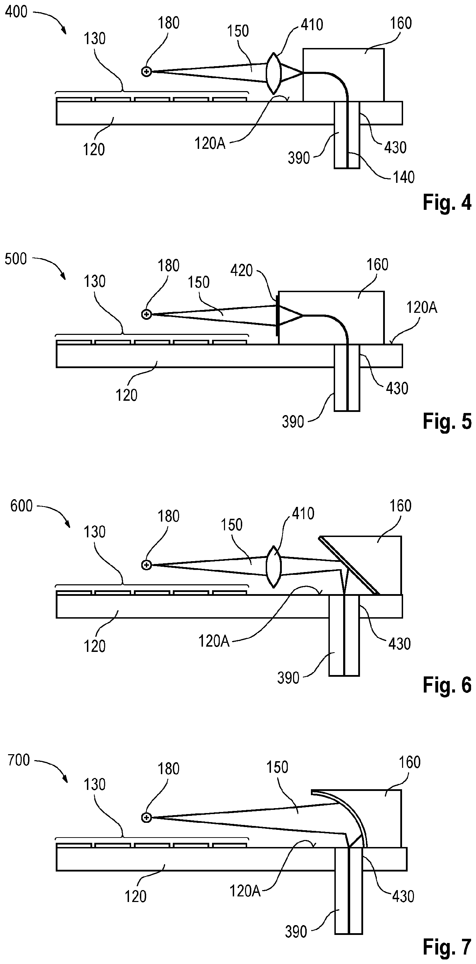

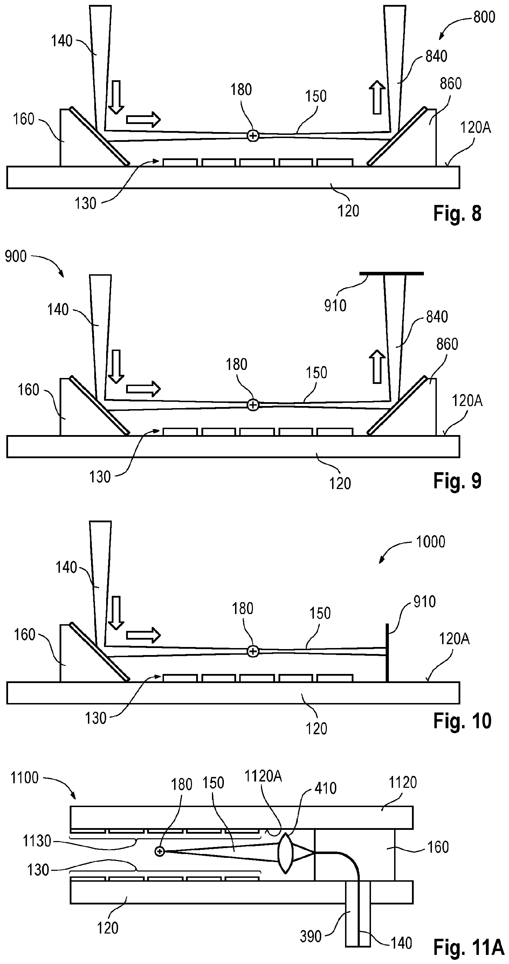

Generally speaking, the laser light path may be divided into three sections: A first section may correspond to the part of the laser light path that directs the laser light to the optical element 160. In the first section, the laser path may include free-space delivery (including free-space optics) such as illustratively shown in Figures 1 and 2, an optical waveguide (as illustratively shown in Figures 4 and 5), or a combination of both. In addition, as will be described further below, in the first section, the laser light may be directed along layers that are substantially parallel to the substrate 120 and optical elements for processing the laser beam may be disposed along the first section of the laser light path in these layers. In addition, the first section may include means to couple laser light from free-space into an optical waveguide and vice versa. In some examples, the first section may be located above the substrate 120 and the laser light may be directed to the optical element 160 from above (as shown in Figures 1 to 3). In other examples, the first section may be located below the substrate 120 and the laser light may be directed to the optical element 160 from below (as shown in Figures 4 to 7). This applies both for 2-dimensional ion traps (as exemplarily shown in Figures 1 to 10) as well as for 3-dimensional ion traps (as exemplarily shown in Figures 11A to 14B).

A second section of the laser light path may include the first optical element 160 that may receive the laser light from a direction perpendicular or inclined to the main surface of the first substrate, and that may redirect the input laser light in a direction substantially parallel to the main surface of the first substrate towards the ion position above the first substrate. The optical element 160 may be a mirror (e.g., a flat mirror or a concave mirror) such as illustratively shown, e.g., in Figures 1 to 3. Alternatively, the optical element may be an optical waveguide as illustratively shown, e.g., in Figures 4 and 5. A third section of the laser may correspond to the part of the laser light path that directs the laser light from the optical element 160 to the position of the ion 180. The third part of the laser light path may include free-space delivery with optional additional optical elements (such as lens 410, shown in Figures 4 and 6, for example). These three sections of the laser light path may be combined in an arbitrary manner and depending on circumstances.

In any of the examples shown in Figures 1 to 15F, focusing optics could be added/realized everywhere along the beam path (i.e., at either one of the first to the third section discussed above, or at a combination of the first to third sections as discussed above), e.g., with curved mirrors, micro lenses, defractive mircrolenses, Fresnel lenses, lenses in contact with a waveguide or GRIN lenses.

Turning to the example shown in Figure 3, the optical access via the optical waveguide 390 may be from the top of the micro-fabricated device 300. In the example shown, the optical element 160 is exemplified by a concave mirror, but can, in general, be any of the optical elements 160 for redirecting the laser light into a direction substantially parallel to the main surface 120A as disclosed herein (such as the flat mirror shown in Figure 1).

Figure 4 illustrates a micro-fabricated device 400 in which the optical waveguide 390 couples from the bottom side to the micro-fabricated device 400. For example, the optical waveguide 390 may be connected with an optical waveguide that is provided in the first substrate 120 (e.g., as a fiber connector 430 provided in the first substrate 120) for fixing the optical waveguide 390 to the first substrate 120.

Moreover, Figure 4 illustrates a further type of a first optical element 160 which can be used for redirecting the input laser light 140 in a direction substantially parallel to the main surface 120A. The first optical element 160 of Figure 4 may, e.g., be implemented by a dielectric element which includes a waveguide, e.g., a short-pulse-laser direct written waveguide known as SPLDW waveguide in the art.

Optionally, the ion trap device may include an optical lens 410 (such as a mirco lens) along the light path of the redirected laser light 150 propagating in the ion trap (i.e., in a direction substantially parallel to the main surface 120A). More specifically, the redirected laser light emitted from the optical element 160 may pass through the optical lens 410, which may converge the laser beam (i.e., the redirected laser light 150) to the position of the ion 180.

Figure 5 illustrates a micro-fabricated device 500, which is similar to the micro-fabricated device 400 of Figure 4 except that the optical lens 410 may be implemented by a diffractive (micro)lens 420 that may directly contact a light emitting surface of the first optical element 160.

Figures 6 and 7 illustrate micro-fabricated devices 600, 700 which are similar to the micro-fabricated device 400 of Figure 4 except that the first optical element 160 is, e.g., a flat (Figure 6) or concave (Figure 7) mirror rather than a waveguide (such as a SPLDW waveguide). Further, similar to Figure 4, a (micro)lens 410 may, e.g., be implemented along the light path of the redirected laser light 150 propagating in the ion trap (i.e., in a direction substantially parallel to the main surface 120A) (as can be seen in Figure 6) or the laser light can be focused by a concave mirror (as can be seen in Figure 7).

Figures 8 and 9 illustrate various concepts for directing laser light (such as the redirected laser light 150) out of the direction that is substantially parallel to the main surface 120A), thereby coupling out laser light from the optical plane of the micro-fabricated devices for trapping ions as described herein. The optical plane as referred to herein is a (fictive) plane that is substantially parallel to the main surface 120A of micro-fabricated device and has a distance from the main surface 120A that is equal to the distance between the position where the ion(s) are to be trapped and the main surface 120A in the micro-fabricated devices described herein. The laser light may be redirected by the first optical element 160 into said optical plane. Similar to the input laser light 140 that can be delivered into the micro-fabricated device 800, 900 in a top-down direction and/or in a bottom-up direction, the laser light from the optical plane of the micro-fabricated devices 800, 900 can be coupled out in the top direction (e.g., see Figures 8 and 9) or in the bottom direction (not shown). Optionally, an optical absorber 910 (see, e.g., Figures 9 and 10) may be used to absorb the laser light either outside the micro-fabricated device 900 after redirecting the laser light out again (Figure 9) or in the optical plane (Figure 10). Coupling out the laser light (as shown in Figures 8 and 9) and/or using an optical absorber 910 in the optical plane (Figure 10) may reduce the occurrence of light scattering and stray light in the optical plane.

More specifically, the micro-fabricated devices 800, 900 may include a second optical element 860 which may be fixedly attached to the first substrate 120. The second optical element 860 may receive laser light 150 from the optical plane. In other words, the incoming laser light 140 is first redirected by the first optical element to enter the optical plane (i.e., the light is directed into a direction substantially parallel to the main surface 120A; such that the path of the laser light lies in the optical plane). Then, the redirected laser light 150 reaches the ion(s) 180 so that the redirected laser light 140 can interact with the ion(s). Then (optionally), the second optical element 860 redirects the laser light 150 (from the optical plane) in a direction perpendicular or inclined to the main surface 120A of the first substrate 120 to guide it out of the optical plane. For example, the second optical element 860 is arranged so that the first optical element 160, the position of the ion(s) and the second optical element form a straight line. This may ensure that the laser light may enter the optical plane, interact with the ion(s) and can leave the optical plane again.

The laser light output from the micro-fabricated devices 800, 900 may be provided, for example, by free-space optics (e.g., Figures 8 and 9) or by means of an optical waveguide (not shown in Figures 8 and 9). The second optical element 860 may, e.g., be implemented by a mirror having, e.g., a flat (e.g., Figures 8, 9) or concave shape. Any implementation disclosed above for the first optical element 160 may be used for the second optical element 860. The elements disclosed in these examples may be combined with each other.

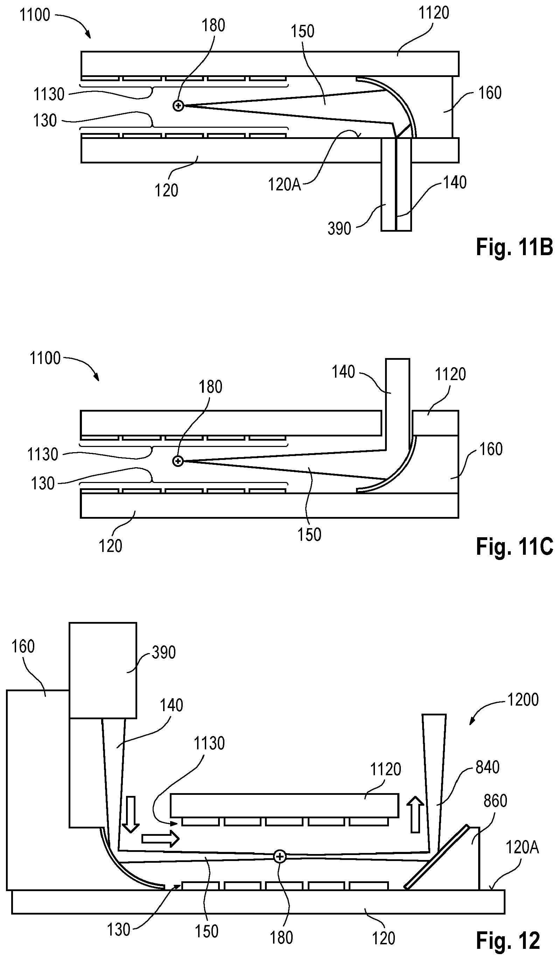

Figures 11A-11C and 12 show examples of micro-fabricated devices 1100, 1200 for controlling trapped ions. Figures 11A-11C only show the first optical element 160. However, the second optical element (for directing the laser light out of the optical plane may also be used in conjunction with the disclosure of Figures 11A-C). The micro-fabricated devices 1100, 1200 are designed as a three-dimensional (3D) ion trap. That is, in addition to the first substrate 120 (already present in the examples shown above), the micro-fabricated devices 1100, 1200 may include a second substrate 1120 spaced apart from the first substrate 120. The positions where one or more ions 180 are trapped (of which only one is depicted in Figures 11A-11C and 12) or, in other words, the optical plane, is located in a space between the first substrate 120 and the second substrate 1120. The first and/or second optical element(s) 160, 860 may be so large that it/they touch the second substrate 1120. In other words, in some examples the first and/or the second optical element can serve as a spacer between the first substrate 120 and the second substrate 1120.

A lower main surface 1120A of the second substrate 1120 may be provided with a structured second metal layer 1130. The structured second metal layer 1130 forms electrodes of the micro-fabricated device 1100, 1200 for trapping ions. 3D ion trap geometries as, e.g., linear Paul trap(s) distinguish over the 2D surface-electrode trap geometries (see, e.g., Figures 1-10) by allowing higher potential depths and higher trap frequencies. However, the provision of laser light input and/or laser light output may be even more complex, as compared to 2D surface-electrode trap geometries.

Basically, the same concepts and features as described above for 2D micro-fabricated devices 100 to 1000 apply for 3D micro-fabricated devices disclosed herein such as, e.g., devices 1100 and 1200, and reference is made to the above description to avoid reiteration. For example, Figure 11A illustrates a 3D version of the 2D micro-fabricated device 400 of Figure 4, Figure 11B illustrates a 3D version of the micro-fabricated device 700 of Figure 7, and Figure 11C illustrates the 3D version of the 2D micro-fabricated device 300 of Figure 3, in which, however, the optical waveguide 390 has optionally been replaced by a free-space optics (see 2D micro-fabricated device 200 of Figure 2). Alternatively, if the input laser light 140 is to be delivered by an optical waveguide 390 (compare, e.g., Figures 3 to 7), the optical waveguide 390 could be fixedly attached by a fiber-connector (not shown) to the second substrate 1120.

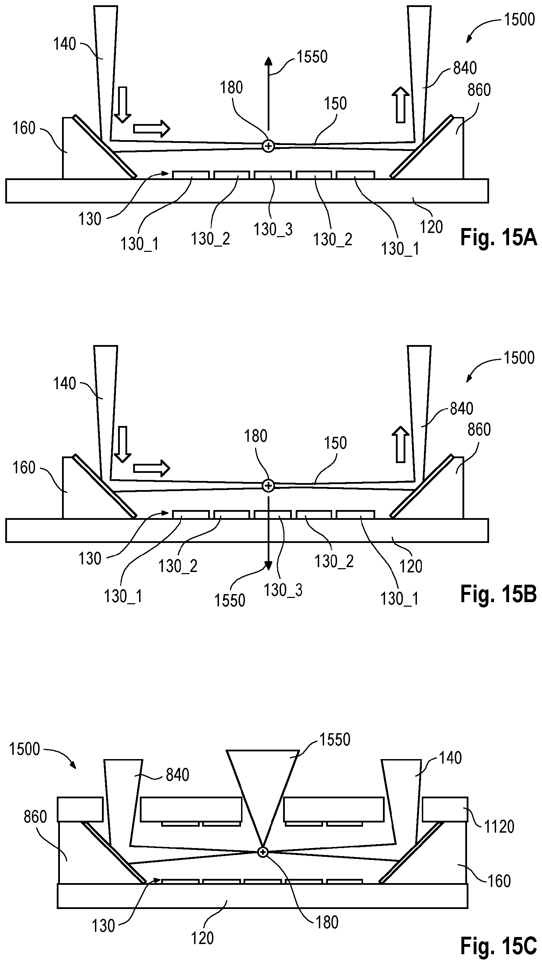

The second substrate 1120 may comprise or be made of one or more of the materials recited above with regard to the first substrate 120. In all examples of 3D micro-fabricated devices, it is possible that the first substrate 120 and the second substrate 1120 are made of the same material or are made of materials different from each other. Further, in all examples of 3D micro-fabricated devices, it is possible that features described in connection with 2D micro-fabricated devices 100 to 1000 are selectively applied, e.g., either to the first substrate 120 or to the second substrate 1120 or both. For example, the second substrate 1120 may include an input port for passing input laser light 140 to the first optical element 160 and/or may include an exit port (not shown in Figures 11A to 11C, but see, e.g., Figures 15C to 15F) for outputting redirected laser light from the second optical element 860.

Figure 12 shows a 3D micro-fabricated device 1200 in which the input laser light 140 is, e.g., introduced by an optical waveguide 390, and output light is discharged from the optical plane by the second optical element 860, which is, e.g., designed as a mirror. The optical waveguide 390 may, e.g., be attached to the first optical element 160 rather than to the second substrate 1120. When the output light 840 redirected by the second optical element 860 is (also) guided by an optical waveguide (not shown in Figure 12), this optical waveguide may be attached to the second optical element 860, for example. In this case, an additional lens may be used to focus the laser light onto the optical waveguide (also not shown in Figure 12).

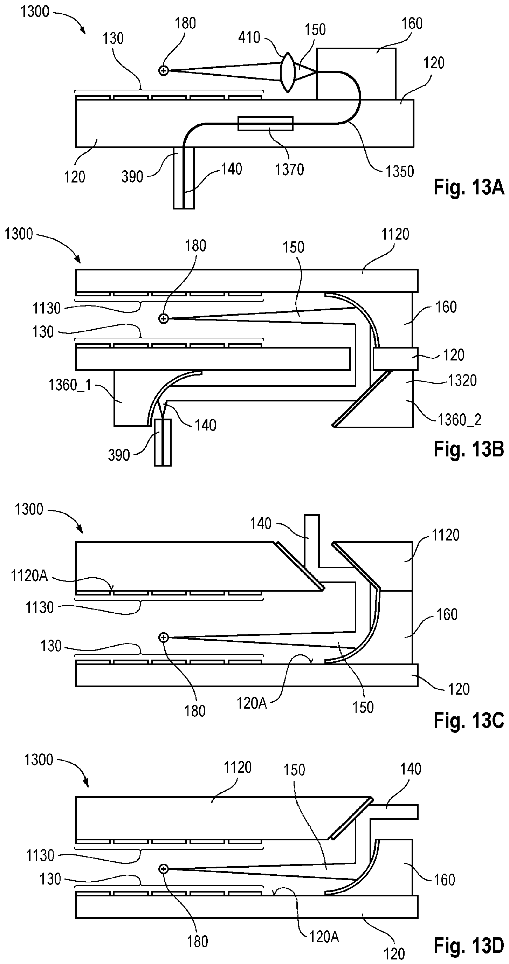

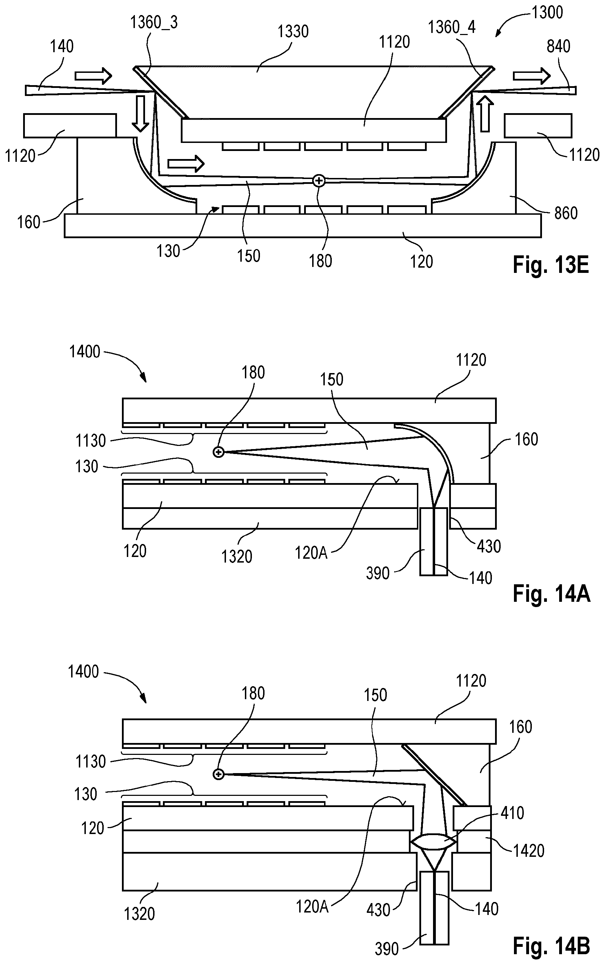

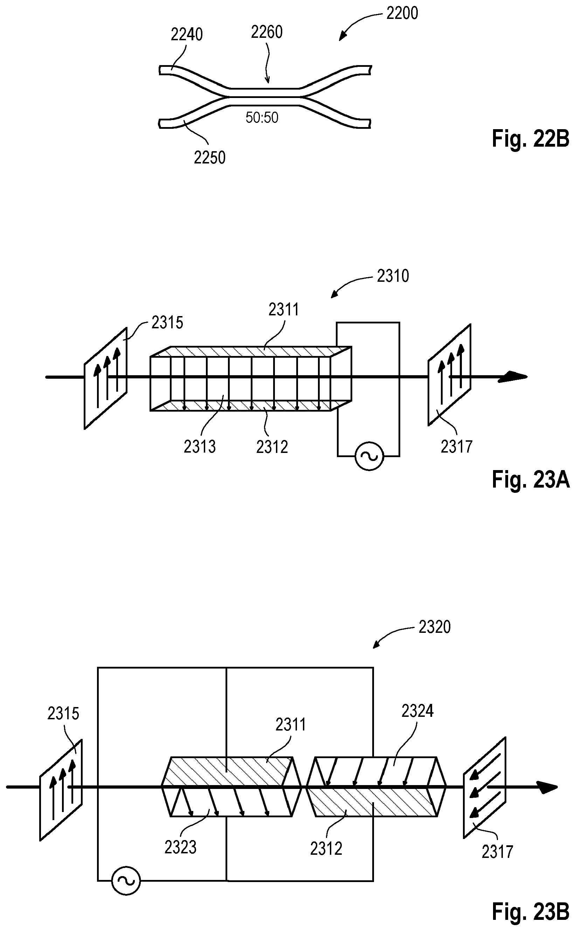

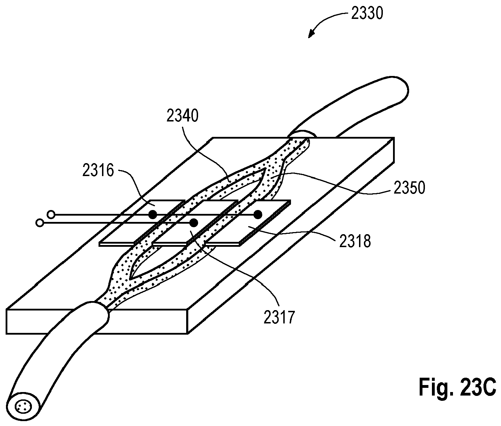

Figures 13A to 13E and 14A to 14B are illustrations of exemplary 2D and 3D micro-fabricated devices 1300, 1400 for controlling trapped ions that have one or more additional layers (also called optical layer in the following) below or above the optical plane. These one or more additional layers may be used for routing the laser light. In addition, or as an alternative, these one or more additional layers may be used for processing the laser light before the laser light enters the optical plane, such as adapting one or more properties of the laser light (e.g., at least one of frequency, spectrum of frequency, polarization, phase, intensity or others). E.g., one or more optical means may be arranged in these one or more additional layers, such as the means shown in Figures 22A, 22B, 23A, 23B and 23C. Other optical elements (such as focusing optics, polarizers, amplifiers may also be arranged in these one or more additional layers. The one or more additional layers above or below the optical plane allow to use the horizontal dimension for laser light routing and laser light processing. As the input laser light 140 is received from a direction perpendicular or inclined to the main surface of the first substrate 120, this device-internal light routing capability may add design flexibility and may improve scaling of the number of laser lights for an ion trap. Adjacent optical layers may be coupled by light paths passing through openings and/or optical elements (e.g., optical vias), as will be shown further below by way of examples.

According to one aspect, an optical layer (as discussed above) may be a layer that is formed in the first substrate 120 as shown in Figure 13A. In addition, or as an alternative, the micro-fabricated device 1300 may comprise a third substrate (not shown) disposed beneath the first substrate, and the layer is formed in the third substrate. In the optical layer, the laser light may propagate in a direction substantially parallel to the surface 120A of the first substrate 120 (or, differently stated, parallel to the light propagation direction in the optical plane). This layer may be used to redistribute the incoming laser light 140 so as to deliver it to the optical element 160 in the optical plane. In addition, or as an alternative, the optical layer may be used to manipulate the laser light (e.g., focus, split, control the intensity and/or phase and/or polarization, block or unblock the laser light) in the optical layer (that is below the optical plane). In one embodiment, manipulating the laser light may also include blocking or unblocking the laser light so that the optical element may be used as a (light) switch to turn the laser light off or on in the vicinity of the ion trap.

Referring to Figure 13A, a 2D micro-fabricated device 1300 is illustrated in which the optical layer is formed in the first substrate 120. For example, the first substrate 120 may be made of a transparent dielectric material and may include a laser light path 1350 (e.g. implemented by a waveguide) extending in a direction substantially parallel to the upper main surface 120A of the first substrate 120. The layer may include one or more light processing elements 1370 (such as one or more of the light processing components shown in Figures 22A, 22B, 23A, 23B and 23C. The one or more light processing elements 1370 may be disposed along the optical path 1350 within the optical layer. The one or more light processing elements 1370 may be used for light manipulation, e.g. for manipulating properties of the laser light such as the intensity and/or polarization of laser light passing the laser light path 1350. Further, the one or more light processing elements 1370 within the laser light path 1350 may comprise beam splitters and/or filters and/or delay elements to manipulate the laser light propagating in the second optical layer.

The laser light manipulation may also be part of laser light distribution. For example, a single laser beam may be split multiple times so that the same laser light can be provided to multiple positions in the micro-fabricated device (e.g., to multiple positions where ion(s) 180 are trapped). A schematic illustration of a beam splitter 2200 (as an example for an light processing element 1370) is shown in Figure 22A. For example, this may be a non-polarizing 50:50 beam spitter 2200. In this case, incident light 2210 is split in transmitted light 2220 (e.g. 500) and refracted light 2230 (e.g. 50%). In addition, multiple beam splitters 2220 may be connected in series to provide, e.g., 4 beams with 25% intensity, 8 beams with 12.50 intensity, and so on. Other types of beam splitters may also be used.

For example, Figure 22B illustrates an exemplary waveguide beam splitter 2200. Two waveguides 2240 and 2250 are coupled in a light coupling zone 2260. In the light coupling zone, the two waveguides are so close to each other that their evanescent fields couple. The length of this interaction zone may be adjusted to a certain coupling e.g. 500. With only one active input, the light is split on both outputs. Additionally, with both inputs, the splitter could be also used as a combiner at the same time.

In additional examples, one or more light processing elements 1370 may be used for light modulation, e.g. phase modulation and/or amplitude modulation. Figure 23A is a schematic illustration of an electro-optical modulator 2310 (as a further example for a light processing element 1370 that can be disposed in the optical layer discussed above) for phase modulation. Applying a voltage to electrodes 2311 and 2312 disposed at a dielectric material 2313 may change the refractive index of the material 2313, resulting in a phase modulation of the exit light beam. In addition, first and (optional) second polarizers 2315, 2317 may be provided upstream and downstream of the dielectric material 2313.

Figure 23B is a schematic illustration of an electro-optical modulator 2320 (as a further example for a light processing element 1370 that can be disposed in the optical layer discussed above) for amplitude modulation and/or polarization modulation. The modulator 2320 may include two orthogonally oriented crystals 2323, 2324 each provided with electrodes 2311, 2312, respectively. With the polarizer 2317, the modulator 2320 may operate as an amplitude modulator. Without the polarizer 2317, the modulator 2320 may rotate the polarization, i.e. operates as a polarization modulator.

Figure 23C illustrates an exemplary electro-optical modulator 2330 (as a further example for a light processing element 1370 that can be disposed in the optical layer discussed above). It may be implemented in an optical layer as an integrated Mach-Zehnder interferometer. Two waveguides 2340, 2350 are split apart in a modulation zone between an input and an output optical waveguide, and electrodes 2316, 2317, 2318 are arranged to both sides and between the waveguides 2340, 2350, respectively. A modulation voltage may be applied between central electrode 2317 and interconnected side electrodes 2316, 2318.

Figures 13B to 13E illustrate examples in which the one or more optical layers are used for laser light propagation in a direction substantially parallel to the direction of propagation of the redirected laser light 150 in the optical plane. As compared to Figure 13A, where the laser path is depicted to be in a waveguide, in Figure 13B the optical layer may include a third optical element 1360_1 and a fourth optical element 1360_2, for example. The device 1300 of Figure 13B is provided with an optical waveguide 390 for the input laser light 140. The input laser light 140 is redirected by the third optical element 1360_1 to propagate in the optical layer to the fourth optical element 1360_2, where it is redirected to enter the optical plane via an input port (e.g. an opening) in the first substrate 120. The one or more light processing elements 1370 (as discussed above) can be provided for the example shown in Figure 13B as well, in the light path that is formed between the third optical element 1360_1 and the fourth optical element 1360_2, similarly as described above (not shown in Figure 13B).

Another difference to the example shown in Figure 13A is that, the micro-fabricated device 1300 shown in Figure 13B may include a third substrate 1320 disposed beneath the first substrate 120. The third and fourth optical elements 1360_1, 1360_2 may be formed in the third substrate. That is, the laser light redistribution layer forming the optical layer may, e.g., be implemented in the third substrate 1320. Of course, the micro-fabricated device shown in Figure 13A, which comprises a waveguide instead of the third and fourth optical elements can also include the second substrate 1120), which is not shown to avoid repetitions.

Figure 13C illustrates an example of a 3D micro-fabricated device 1300 in which the optical layer is formed above the lower main surface 1120A of the second substrate 1120. More specifically, the optical layer may be formed in the second substrate 1120, for example. The optical layer includes a laser light path extending in a direction substantially parallel to the main surface 120A of the first substrate 120 (and/or to the main surface 1120A of the second substrate 1120). The input laser light 140 enters the optical layer (formed in the second substrate 1120) in a direction inclined or perpendicular to the upper main surface 120A of the first substrate 120.

Figure 13D illustrates a variant of the 3D micro-fabricated device 1300 of Figure 13C in which the optical layer, implemented in the second substrate 1120, provides for an entry of the input laser light 140 into the optical layer from a direction substantially parallel to the light propagation direction in the optical plane (i.e. substantially parallel to the upper main surface 120A of the first substrate 120).

Figure 13E illustrates an example of a 3D micro-fabricated device 1300 which is similar to the device of Figure 13D except that the second substrate 1120 additionally provides for an exit port (e.g. opening) of laser light discharged from the optical plane. To that end, fifth and sixth optical elements 1360_3, 1360_4 may be provided to receive and/or redirect laser light which is substantially parallel to the upper main surface 120A of the first substrate 120, respectively. In the example shown, these optical elements 1360_3, 1360_4 may be implemented in a fourth substrate 1330 disposed above the second substrate 1120. That is, in this specific example the fifth and sixth optical elements 1360_3, 1360_4 are formed in the fourth substrate 1330. However, it is also possible that the fifth and sixth optical elements 1360_3, 1360_4 are formed in the second substrate 1120, similar to that shown in Figures 13C and 13D.

It is to be noted that any of the features described in connection with Figures 13A to 13E and the optical layer may be applied to examples where the optical layer is located within or below the first substrate 120, or to examples where the optical layer is located within or above the second substrate 1120. For example, for Figures 13A and 13B this would mean that the light can also enter into the optical plane from the second substrate located above the optical plane (not shown in Figure 13A) or for Figure 13D that the light can enter from the left side as well. In addition, the example shown in Figure 13A could be implemented such that the incoming light comes from the first substrate and the exiting light leaves through the second substrate or vice versa. In addition, the examples shown in Figures 13A to 13D may in addition have an additional exit port through which the laser light can be passed out (as shown, e.g., for example 13E).

Figures 14A and 14B illustrate 3D micro-fabricated devices 1400 for controlling trapped ions in which a third substrate is used to couple input laser light 140 into the optical plane and/or to out-couple laser light from the optical plane. For example, the third substrate may be configured to mount optical waveguides. More specifically, in Figure 14A the third substrate 1320, disposed beneath the first substrate 120, is used to mount the optical waveguide 390 so as to allow the input laser light 140 to pass an input port (e.g. opening) in the first substrate 120. Similarly, an optical waveguide (not shown in Figure 14A) for outputting laser light from the optical plane may be mounted to the third substrate 1320.

As shown in Figure 14B, a fifth substrate 1420 may be disposed between the first substrate 120 and the third substrate 1320. For example, the fourth substrate may be configured to receive focal optical elements such as, e.g., a spherical (micro)lens 410, a diffractive lens 420 (cf. Figure 5), etc.

In addition to the above, the micro-fabricated device may comprise an additional opening for allowing light that is emitted from the ion 180 to exit the space between the first and the second substrate. This may be needed in order to read out the light emitted from the ion (e.g., in quantum computing applications). The detection of a quantum state of the ion(s) 180 may be performed by detecting its fluorescence light or the absence of fluorescence light. Generally, as illustrated in Figures 15A to 15F, fluorescence light 1550 from the ion(s) 180 may be detected either from the top of a micro-fabricated device 1500 (see, e.g. Figures 15A, 15C to 15F) or from the bottom of the micro-fabricated device 1500 (see, e.g., Figure 15B). Differently stated, input laser light 140 may be provided from the top or from the bottom of the micro-fabricated device 1500 and fluorescence light 1550 may, e.g., be directed to the top or to the bottom of the micro-fabricated device 1500 for detection.

More specifically, Figure 15A illustrates an example in which fluorescence light 1550 is collected from the top of the 2D micro-fabricated device 1500, while Figure 15B illustrates an example of a 2D micro-fabricated device 1500 in which the fluorescence light 1550 is collected from the bottom of the micro-fabricated device 1500. In Figure 15B, the first substrate 120 may be transparent for passing the fluorescence light 1550. Further, the structured first metal layer 130 may be transparent (i.e. may include transparent electrodes) to allow fluorescence light 1550 to pass the output port.

Figures 15C-15F illustrate examples of micro-fabricated devices 1500 in which, e.g., input laser light 140, fluorescence light 1550 and (optionally) redirected output laser light 840 which is discharged from the optical plane passes through the second substrate 1120. Alternatively, the first substrate 120 may likewise be configured to provide for these functionalities. In addition, it is contemplated that some of these functionalities are performed by the first and the second substrate (e.g., the laser light could enter via the first substrate and exit via the second substrate or vice versa and the fluorescent light could exit via the first or the second substrate).

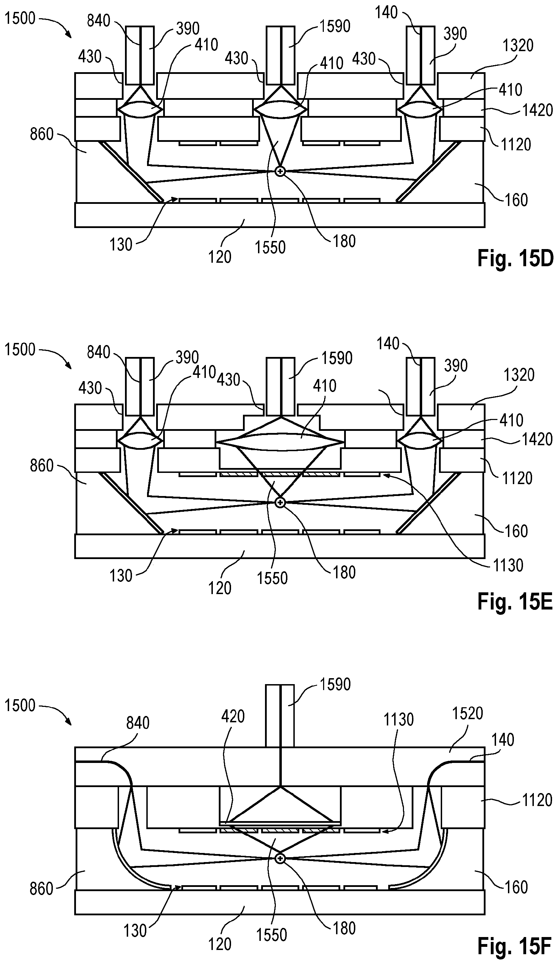

For example, Figure 15C illustrates a 3D micro-fabricated device 1500 in which the input laser light 140 and the fluorescence laser light 1550 (and optionally, the output laser light 840 discharged from the optical plane) is handled by free-space optics. In contrast, in Figures 15D and 15E, optical waveguides 390, 1590 are used to deliver the input laser light 140, to guide the fluorescence light 1550 and (optionally) to discharge the output laser light 840 from the optical plane. While in Figure 15D the fluorescence light 1550 is coupled to an optical waveguide 1590 by a small-scale optic device (e.g. (micro)lens 410), Figure 15E illustrates an example in which a large-scale optic device (e.g. large lens 410) is used to couple the fluorescence light 1550 into the optical waveguide 1590.

Further, Figure 15E illustrates that the structured second metal layer 1130 may, e.g., be at least partly transparent to allow the fluorescence light 1550 to be collected by the large lens 410 of the large-scale optics and focused into the optical waveguide 1590. In contrast, in Figure 15D, the optical port for out-coupling the fluorescence light 1550 may, e.g., be provide by an opening in the second substrate 1120.

In Figures 15D and 15E the 3D micro-fabricated devices 1500 may be provided with third substrates 1320 which are disposed over the second substrate 1120. As described in connection with Figures 14A and 14B, the third substrates 1320 may accommodate fiber connectors 430 to mount optical waveguides 390, 1590

Further, as described in connection with Figure 14B, the micro fabricated device may comprise a fifth substrate 1420 configured to accommodate focal optical elements (e.g. lenses 410).

Figure 15F illustrates a further example of a 3D micro-fabricated device 1500. This device 1500 is, e.g., provided with a sixth substrate 1520 disposed over the second substrate 1120. The sixth substrate 1520 may include waveguides for the input laser light 140 and/or the fluorescence laser light 1550 and/or the redirected output laser light 840 discharged from the optical plane.

Similar as in Figure 15E the electrodes of the structured second metal layer 1130 may be transparent. Further, in Figure 15F a diffractive micro-lens or a Fresnel lens 420 may be used for the fluorescence light output port rather than a (spherical) lens 410 as shown in Figure 15E.

Figures 16 and 17 illustrate possible layer stacks of a 2D micro-fabricated device and layer stacks of a 3D micro-fabricated device, respectively.

In the conceptual representation of a 2D micro-fabricated device of Figure 16 the optical plane of the 2D micro-fabricated device is denoted by reference sign OP. This plane is the ion trapping position and, e.g., the optical elements 160, 860 are integrated. Below the optical plane OP, an electrical layer EL may, e.g., be located. The electrical layer EL may, e.g., be integrated in the first substrate 120 or in a substrate below. The electrical layer EL may comprise, e.g., circuitry and/or electrical interconnect for driving the trap electrodes 130_1, 130_2, 130_3 of the 3D micro-fabricated device. As discussed above, the optical layers and the electrical layer may be part of the first substrate 120 or disposed, e.g., above (EL) or below (OL1, OL2, OL3) the first substrate 120.

Below the optical plane OP and the (optional) electrical layer EL, a plurality of optical layers OL1, OL2 and OL3 may be located. These optical layers OL1, OL2, OL3 may be used for accommodating one or more light processing elements 1370 in each one of the optical layers. In addition, the optical layers may be connected to each other via optical vias so as to form a common laser light path. For example, the third optical layer OL3 may be connected to the second optical layer OL2, the second optical layer OL2 may be connected to the first optical layer OL1. The third optical layer OL3 may comprise a port (such as an opening) for receiving laser light. The laser light may then be guided through each one of the optical layers and then to the optical plane OP. Along the light path light processing elements 1370 can be disposed (such as in each one of the optical layers OL1, ..., OL3). As such, light manipulation can be performed in a layer that is parallel to the optical plane and below the optical plane. This may save space in the construction of micro-fabricated devices for trapping ions and may allow scaling of the number of laser lights that can be provided to the ions. Of course, there may also be only one optical layer, two optical layers or more. Three optical layers as described above are only intended as an example.

In the conceptual representation of a 3D micro-fabricated device of Figure 17 the optical plane OP of the 3D micro-fabricated device is, e.g., arranged below optical layers OL1, OL2, OL3. For example, the electrical layer EL may be part of the first substrate 120 or of a substrate below, while the optical layers OL1, OL2, OL3 may be part of the second substrate 1120 or of one or more substrates above the second substrate 1120. In this case, the electrical layer EL and the optical layers OL1, OL2, OL3 are separated by the optical plane OP. In other examples, the electrical layer EL and the optical layers OL1, OL2, OL3 may be part of the second substrate 1120. Alternatively, these layers may be separate layers that are disposed on (OL1, OL2 and OL3) or below the second substrate (EL), for example. Again, the electrical layer EL may accommodate circuitry and/or electrical interconnect for driving the electrodes 130, 1130 of the 3D micro-fabricated device. These optical layers OL1, OL2, OL3 may be used for accommodating one or more light processing elements 1370 in each one of the optical layers, similar as discussed above with regard to Figure 16. The only difference is that the laser light in Figure 17 may enter from above into the optical plane OP, whereas it may enter the optical plane OP from below in Figure 16.

Generally, all features of the above examples can be arbitrarily combined or interchanged if not restricted by physical limitations. The mirrors (e.g. optical elements 160, 860) may, e.g., be fabricated by laser structuring of a wafer of a dielectric material, e.g., a glass wafer. The dielectric material can be metallized to achieve high reflectivity, and bonded to the first substrate 120 and/or second substrate 1120 by wafer bonding techniques. This process is compatible with the process of structuring the first metal layer 130 and/or the second metal layer 1130 by micro-fabrication technology using, e.g., lithography and etching.

Alternatively, the 2D or 3D micro-fabricated devices may be assembled by using a pick-and-place process to place, e.g., the optical elements 160, 860 and/or other elements implemented in the various layers on or above or below the first substrate 120, for example.

Generally, the concept of a 2D or 3D micro-fabricated device for controlling trapped ions using different layers (see in particular Figures 16 and 17) which are vertically coupled, e.g. electrically and/or optically, allows for allocating specific functions to specific layers. Electrically, the vertical connection between different layers may be performed through vias. Optically, the vertical connection between different layers can use waveguides (such as SPLDW waveguides), free space optics and/or optical vias to couple different optical layers, namely the optical layers OL1, OL2 and/or OL3.

For example, as mentioned above, the light of external optical waveguides may be coupled into one optical layer. The different light frequencies may be distributed to individual regions in the same or another optical layer. In, e.g., another optical layer, the intensity and/or polarization of the laser light may be controlled. And in still another optical layer the light may be polarized. As disclosed above, light focusing may be carried out either in the optical plane or in an additional substrate, see, e.g., the fifth substrate 1420 of Figures 15D, 15E.

Further, as described above, on the exit side the light from the optical plane OP can be recoupled to an optical waveguide or sent to a beam absorber or emitted as a free space beam.

By leveraging multiple 2D layer geometries (e.g., OP, EL, OL1, OL2, OL3, ...) and coupling them vertically, the scaling problem of trapped ion quantum computing may be reduced. Complex scenarios of laser beam configurations with different wavelength, stabilized intensities and controlled polarizations can be managed. For example, the available 2D area of an ion trap can remain small and there may be no need for adding large laser equipment to the 2D area. Instead, the laser redistribution and manipulation can be achieved above or below the available 2D area by using the third dimension, i.e. in the direction perpendicular to the 2D area structure and by redirecting the laser light from above or from below into the optical plane OP where the ions may be positioned.

Further, laser light which propagates parallel to the main surface 120A of the first substrate 120 avoids interacting with surfaces of the 2D or 3D micro-fabricated devices. That is, while vertical light input and/or light output may allow for scaling of the micro-fabricated device, horizontal light redistribution in specific optical layers and horizontal light propagation in the optical plane OP provide for low interference in the device. In particular, the concept of horizontal laser light propagation in various optical layers may allow to use laser light exit ports which are remote from the position of the ion(s) 180.

In addition, another feature may be that the optics may be designed to operate with UV (ultra-violet) laser light as well as with NIR (near infrared) laser light. For cooling of trapped ions 180, UV laser light beams and NIR laser light beams typically need to overlap at the position of the ion 180. In the above disclosure, the optical elements 160, 860, 410 may be designed to operate with both UV and NIR laser light beams.

### EXAMPLES

The following examples pertain to further aspects of the disclosure:
Example 1 is a micro-fabricated device for controlling trapped ions includes a first substrate having a main surface. A structured first metal layer is disposed over the main surface of the first substrate, the structured first metal layer comprising a plurality of electrodes configured to trap an ion at a position above the first substrate. A first optical layer is disposed beneath or over the position, the first optical layer comprising a first laser light path extending in a direction substantially parallel to the main surface of the first substrate, wherein the first optical layer comprises one or more light processing elements for manipulating laser light on the first laser light path.
In Example 2, the subject matter of Example 1 can optionally include wherein the first optical layer is formed in the first substrate.
In Example 3, the subject matter of Example 1 can optionally include wherein the micro-fabricated device further comprises a second substrate disposed beneath the first substrate, and wherein the first optical layer is formed in the second substrate.
In Example 4, the subject matter of any of Example 1 can optionally include wherein the micro-fabricated device further comprises a second substrate disposed over the first substrate and spaced apart from the first substrate, wherein the position is located in a space between the first substrate and the second substrate, and wherein the first optical layer is formed in the second substrate.
In Example 5, the subject matter of any of the preceding Examples can optionally include wherein the one or more light processing elements manipulate the laser light by at least one of: controlling an intensity, a phase, and a polarization of the laser light passing the first laser light path; and/or wherein the one or more light processing elements manipulate the laser light by blocking the laser light.
In Example 6, the subject matter of any of the preceding Examples can optionally include wherein the micro-fabricated device further comprises a first optical element fixedly attached to the first substrate, the first optical element configured to: receive input laser light from the first laser light path, and redirect the input laser light in a direction substantially parallel to the main surface of the first substrate towards the position above the first substrate.
In Example 7, the subject matter of Example 1 can optionally include wherein the micro-fabricated device further comprises a second optical layer comprising a second laser light path extending in a direction substantially parallel to the main surface of the first substrate.
In Example 8, the subject matter of Example 7 can optionally include wherein the first optical layer and the second optical layer are formed in the first substrate, wherein the second optical layer is disposed beneath the first optical layer, or wherein the micro-fabricated device further comprises a second substrate disposed beneath the first substrate, wherein the first optical layer is formed in the first substrate, and wherein the second optical layer is formed in the second substrate, or wherein the micro-fabricated device further comprises a second substrate disposed over the first substrate and spaced apart from the first substrate, wherein the position is located in a space between the first substrate and the second substrate, and wherein the first optical layer and the second optical layer are formed in the second substrate.
In Example 9, the subject matter of Examples 7 or 8 can optionally include wherein the first laser light path and the second laser light path are coupled via optical vias.
In Example 10, the subject matter of any of the preceding Examples can optionally include wherein at least one of the first substrate and the second substrate comprises an input port for passing laser light to at least one of the first laser light path and the second laser light path.
In Example 11, the subject matter of any of the preceding Examples can optionally include wherein at least one of the first substrate and the second substrate comprises an output port for receiving at least one of the laser light and fluorescent light from the ion position.
In Example 12, the subject matter of Example 7 can optionally include wherein the micro-fabricated device further comprises a third optical layer comprising a third laser light path extending in a direction substantially parallel to the main surface of the first substrate.
In Example 13, the subject matter of Example 12 can optionally include wherein the first optical layer, the second optical layer and the third optical layer are formed in the first substrate, and wherein the first laser light path, the second laser light path and the third laser light path are coupled via optical vias.
In Example 14, the subject matter of Example 12 can optionally include wherein the first optical layer, the second optical layer and the third optical layer are formed in a second substrate disposed over the first substrate and spaced apart from the first substrate, wherein the position is located in a space between the first substrate and the second substrate, and wherein the first laser light path, the second laser light path and the third laser light path are coupled via optical vias.
In Example 15, the subject matter of any Example 12 can optionally further include wherein wherein the first optical layer is formed in a second substrate, wherein the second optical layer is formed in a third substrate, and wherein the third optical layer is formed in a fourth substrate.
   Further examples disclosed herein are directed to light redirection without, however, requiring light manipulation above and/or below the optical plane as recited in the Examples above.
Example 16 is a micro-fabricated device for controlling trapped ions includes a first substrate having a main surface. A structured first metal layer is disposed over the main surface of the first substrate, the structured first metal layer comprising a plurality of electrodes configured to trap an ion at a position above the first substrate. The micro-fabricated device further includes a first optical element fixedly attached to the first substrate, the first optical element is configured to receive input laser light from a direction perpendicular or inclined to the main surface of the first substrate, and to redirect the input laser light in a direction substantially parallel to the main surface of the first substrate towards the ion position above the first substrate.
In Example 17, the subject matter of Example 16 can optionally include wherein the first optical element is a mirror or a waveguide.
In Example 18, the subject matter of Example 16 or 17 can optionally include wherein the direction of the input laser light is a bottom up direction, and the first substrate comprises an input port for passing the input laser light to the first optical element.
In Example 19, the subject matter of any of Examples 16 or 2 can optionally include wherein the direction of the input laser light is a top down direction.
In Example 20, the subject matter of any of the Examples 16 to 19 can optionally further include a second optical element fixedly attached to the first substrate, the second optical element configured to receive laser light from the ion position in a direction substantially parallel to the main surface of the first substrate, and redirect the laser light from the ion position in a direction perpendicular or inclined to the main surface of the first substrate.
In Example 21, the subject matter of any of the Examples 16 to 20 can optionally further include a second substrate spaced apart from the first substrate, wherein the ion position is located in a space between the first substrate and the second substrate.
In Example 22, the subject matter of Example 21 can optionally include wherein the second substrate comprises an input port for passing the input laser light to the first optical element.
In Example 23, the subject matter of any of Examples 20 to 22 can optionally include wherein the second substrate comprises an exit port for passing the redirected laser light from the second optical element.
In Example 24, the subject matter of any of Examples 21 to 23 can optionally include wherein the second substrate comprises an output port in proximity of the ion position for passing fluorescence light from the ion position.
In Example 25, the subject matter of any of the Examples 16 to 24 can optionally further include a first layer beneath the main surface of the first substrate, the first layer comprising a laser light path extending in a direction substantially parallel to the main surface of the first substrate.
In Example 26, the subject matter of Example 25 can optionally further include wherein the first layer is formed in the first substrate, or the micro-fabricated device comprises a third substrate disposed beneath the first substrate, and the first layer is formed in the third substrate.
In Example 27, the subject matter of Example 25 or 26 can optionally further include a second layer beneath the main surface of the first substrate, the second layer comprising a laser light path extending in a direction substantially parallel to the main surface of the first substrate, wherein the laser light paths of the first and second layers are coupled via optical vias.
In Example 28, the subject matter of any of Examples 21 to 24 can optionally further include a third layer above a main surface of the second substrate facing the main surface of the first substrate, the third layer comprising a laser light path extending in a direction substantially parallel to the main surface of the first substrate.
In Example 29, the subject matter of Example 28 can optionally include wherein the third layer is formed in the second substrate, or the micro-fabricated device further comprises a fourth substrate disposed above the second substrate, and the third layer is formed in the fourth substrate.
In Example 30, the subject matter of any of Examples 25 to 29 can optionally further include wherein at least one of the first layer, the second layer or the third layer comprises one or more light processing elements for controlling an intensity and/or a phase and/or a polarization of laser light passing the laser light path.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A micro-fabricated device for controlling trapped ions, the device comprising:
a first substrate having a main surface;
a structured first metal layer disposed over the main surface of the first substrate, the structured first metal layer comprising a plurality of electrodes configured to trap an ion at a position above the first substrate; and
a first optical layer disposed beneath or over the position, the first optical layer comprising a first laser light path extending in a direction substantially parallel to the main surface of the first substrate,
wherein the first optical layer comprises one or more light processing elements for manipulating laser light on the first laser light path.

2. The micro-fabricated device of claim 1,
wherein the first optical layer is formed in the first substrate.

3. The micro-fabricated device of claim 1,
wherein the micro-fabricated device further comprises a second substrate disposed beneath the first substrate, and
wherein the first optical layer is formed in the second substrate.

4. The micro-fabricated device of claim 1,
wherein the micro-fabricated device further comprises a second substrate disposed over the first substrate and spaced apart from the first substrate,
wherein the position is located in a space between the first substrate and the second substrate, and
wherein the first optical layer is formed in the second substrate.

5. The micro-fabricated device of any one of the preceding claims,
wherein the one or more light processing elements manipulate the laser light by at least one of: controlling an intensity, a phase, and a polarization of the laser light passing the first laser light path; and/or
wherein the one or more light processing elements manipulate the laser light by blocking the laser light.

6. The micro-fabricated device of any one of the preceding claims,
wherein the micro-fabricated device further comprises a first optical element fixedly attached to the first substrate, the first optical element configured to:
receive input laser light from the first laser light path, and
redirect the input laser light in a direction substantially parallel to the main surface of the first substrate towards the position above the first substrate.

7. The micro-fabricated device of any of claim 1,
wherein the micro-fabricated device further comprises a second optical layer comprising a second laser light path extending in a direction substantially parallel to the main surface of the first substrate.

8. The micro-fabricated device of claim 7,
wherein the first optical layer and the second optical layer are formed in the first substrate, wherein the second optical layer is disposed beneath the first optical layer, or
wherein the micro-fabricated device further comprises a second substrate disposed beneath the first substrate, wherein the first optical layer is formed in the first substrate, and wherein the second optical layer is formed in the second substrate, or wherein the micro-fabricated device further comprises a second substrate disposed over the first substrate and spaced apart from the first substrate, wherein the position is located in a space between the first substrate and the second substrate, and wherein the first optical layer and the second optical layer are formed in the second substrate.

9. The micro-fabricated device of claim 7 or 8,
wherein the first laser light path and the second laser light path are coupled via optical vias.

10. The micro-fabricated device of any of the preceding claims, wherein at least one of the first substrate and the second substrate comprises an input port for passing laser light to at least one of the first laser light path and the second laser light path.

11. The micro-fabricated device of any of the preceding claims, wherein at least one of the first substrate and the second substrate comprises an output port for receiving at least one of the laser light and fluorescent light from the ion position.

12. The micro-fabricated device of claim 7,
wherein the micro-fabricated device further comprises a third optical layer comprising a third laser light path extending in a direction substantially parallel to the main surface of the first substrate.

13. The micro-fabricated device of claim 12,
wherein the first optical layer, the second optical layer and the third optical layer are formed in the first substrate, and wherein the first laser light path, the second laser light path and the third laser light path are coupled via optical vias.

14. The micro-fabricated device of claim 12,
wherein the first optical layer, the second optical layer and the third optical layer are formed in a second substrate disposed over the first substrate and spaced apart from the first substrate,
wherein the position is located in a space between the first substrate and the second substrate, and
wherein the first laser light path, the second laser light path and the third laser light path are coupled via optical vias.

15. The micro-fabricated device of claim 12,
wherein the first optical layer is formed in a second substrate, wherein the second optical layer is formed in a third substrate, and
wherein the third optical layer is formed in a fourth substrate.
